# EUROPÄISCHE PATENTSCHRIFT

(11) **EP 1 301 443 B1**
(45) Veröffentlichungstag und Bekanntmachung des Hinweises auf die Patenterteilung: **26.11.2003**
(21) Anmeldenummer: 01960013.9
(22) Anmeldetag: 07.08.2001
(51) Int. Cl.: C03B 13/14, F24J 2/50, C03C 17/00

(54) **GLASSCHEIBE**
GLASS PANE
PANNEAU DE VERRE

(30) Priorität: 15.02.2001 CH 268012001; 20.04.2001 CH 721012001
(43) Veröffentlichungstag der Anmeldung: 16.04.2003
(73) Patentinhaber: Interfloat Corporation, 9493 Mauren (LI)
(72) Erfinder: WEIKINGER, Josef, FL-9493 Mauren (LI)
(74) Vertreter: Hasler, Erich, Dr.
(86) Internationale Anmeldenummer: CH0100480
(87) Internationale Veröffentlichungsnummer: WO02064518

(56) Entgegenhaltungen:
- EP-A- 0 493 202
- EP-A- 0 968 968
- US-A- 4 261 706
- US-A- 5 663 110

## Beschreibung

Die Erfindung betrifft eine Glasscheibe, insbesondere für die Verwendung in Solaranwendungen.

In Solarzellen für die Photovoltaik (Umwandlung von Sonnenenergie in Strom) als auch in thermischen Solarzellen zur Gewinnung von Wärmeenergie mittels Wärmetauschern werden hochwertige Gläser mit einer hohen Transmission für die Sonnenstrahlung eingesetzt. In Solarzellen werden Glasscheiben als Träger für die Halbleiterschichten verwendet, die für die Umwandlung der Lichtenergie in Strom verantwortlich sind. Thermische Solarzellen bestehen im wesentlichen aus einem flachen Wärmetauscher, welcher hinter einer Glasscheibe angeordnet ist. Die Glasscheibe isoliert den Wärmetauscher thermisch von der Umgebungsluft, damit möglichst wenig der eingefangenen Sonnenstrahlung wieder an die Umgebung abgegeben wird.

Thermische als auch Photovoltaik-Solarzellen haben einen grossen Platzbedarf, da die Energiegewinnung direkt von der bestrahlten Fläche abhängt. Auf Hausdächern oder an Fassaden angeordnete Solargläser sollen möglichst viel der Sonnenstrahlung durchlassen und möglichst wenig reflektieren. Die Reflexion von Strahlung ist aber nicht nur aus energetischen Ueberlegungen unerwünscht, denn reflektierende Glasflächen können in Wohnsiedlungen Nachbarn oder den Verkehr stören. Zur Vermeidung dieses Problems werden in Solarzellen Glasscheiben verwendet, welche auf der einen Seite matt sind. Matte Glasscheiben haben auch den Vorteil, dass Verschmutzungen weniger stark wahrgenommen werden.

Bekannt sind Glasscheiben mit einseitiger Mikrostruktur. Solche matte Glasscheiben werden hergestellt, indem das aus einer Glasschmelze gezogene Glas mit einer Walze geprägt wird, d.h. mit einer Mikrostruktur versehen wird. Diese Glasscheiben haben den Nachteil, dass die Durchlässigkeit für die Sonnenstrahlung je nach Einfallswinkel oft stark abnimmt. Ein weiterer Nachteil ist, dass einseitig geprägte Glasscheiben oft falsch eingebaut werden, d.h. die matte Glasoberfläche z.B. wärmetauscherseitig anstatt umgebungsseitig angeordnet wird. Durch einen falschen Einbau der Glasscheiben verschlechtern sich jedoch Transmissions- und Reflexionswerte.

Die EP-A-0 493 202 betrifft eine diffuse Glasscheibe mit einer Oberflächenstruktur bestehend aus identischen pyramidalen Kratern, deren Abstand von einander kleiner ist als deren grösster Durchmesser. Die pyramidalen Krater haben vorzugsweise eine quadratische oder hexagonale Basis. Die Kantenlänge kann zwischen 0.5 und 1.7 mm variieren. Die Tiefe der Strukturen ist vorzugsweise 0.85 mm. Mit der von der EP-A-0 493 202 vorgeschlagenen Strukturierung kann zwar eine diffuse Glasscheibe zur Verfügung gestellt werden, doch eignet sich eine soche Glasscheibe wegen der im Vergleich zu flachem Glas schlechteren Transmission nicht für Solaranwendungen.

Die EP-A-0 968 968 offenbart eine Pressform mit einem ersten Vorsprung mit dreieckigem Querschnitt und einem zweiten Vorsprung mit trapezoidalem Querschnitt. Die Form wird dazu benützt, um in einem Werkstück, z.B. einem Glassubstrat, eine V-förmige Vertiefung und eine invers trapezodiale Vertiefung herzustellen. Die invers trapezodiale Vertiefung hat vorzugsweise eine Tiefe zwischen 1 und 20 µm und kann zur Ausrichtung des Werkstückes dienen. Es können eine Mehrzahl von Ausrichtmarkierungen auf einem als Maske dienenden Glassubstrat vorgesehen sein. Die Strukturen werden zur Ausrichtung eines Substrats und einer Maske in einem photolithographischen Prozess eingesetzt. Da nur vereinzelte Strukturen in einem grösseren Abstand voneinander in einem Glassubstrat hergestellt werden, sind die Glassubstrate keine diffus streuenden Glasscheiben.

Die US-A-4,262,706 betrifft die kontinuierliche Herstellung von identischen, diskreten Teilchen aus plastisch verformbaren Material. Die Herstellung der Teile geschieht, indem ein plastisch verformbares Material beispielsweise zwischen zwei Walzen, welche eine Oberflächenstruktur aufweisen, hindurchgepresst wird. Obwohl auch geschmolzenes Glas verarbeitbar ist, ist es kein erklärtes Ziel der US-A-4,261,706, strukturierte Glasscheiben mit erhöhter Transmission bereitzustellen. Im Gegenteil: Die zu Beginn als zusammenhängendes Band vorliegenden dreidimensionalen Teilchen sind lediglich entlang der Kanten oder durch eine dünne Materialschicht miteinander verbunden, sodass diese leicht auseinandergebrochen und in Einzelteilchen zerlegbar sind. Die dreidimensionalen Strukturen sind denn auch durchwegs grösser als wenigstens ¼ mm.

Aufgabe der vorliegenden Erfindung ist es, ein verbessertes Glas resp. Glasscheiben für Solaranwendungen bereitzustellen. Die Glasscheiben sollen eine möglichst hohe Transmission und geringe Reflexion für Sonnenstrahlung haben. Auch soll die Gefahr verringert sein, dass die Glasscheiben falsch in die Solarzellen eingebaut werden.

Erfindungsgemäss ist die Aufgabe dadurch gelöst, dass wenigstens eine Glasoberfläche eine Mikrostruktur aufweist, welche aus Erhebungen und dazwischenliegenden Tälern besteht und der Höhenunterschied zwischen Erhebung und Tal (peak to valley) maximal 50 µm, vorzugsweise maximal 30 µm und ganz besonders bevorzugt 20 µm beträgt. Der Vorteil einer auf beiden Glasoberflächen eine dreidimensionale Mikrostruktur oder Relief aufweisenden Glasscheibe besteht darin, dass das Glas in Solarzellen in beliebiger Orientierung eingebaut werden kann. Überraschenderweise besitzen beidseitig strukturierte Gläser ein Transmissionsvermögen, das demjenigen von einseitig strukturierten Glasscheiben entspricht oder überlegen ist. Untersuchungen haben gezeigt, dass derart ausgebildete reliefartige Strukturen ein hohes Transmissionsvermögen der Gläser gewährleisten. Ein weiterer Vorteil von derartige Mikrostrukturen aufweisenden Glasscheiben ist, dass der Winkelfaktor, d.h. das Verhältnis des solaren Transmissionsgrades unter variablem Einfallswinkel relativ zu senkrechtem Einfall, dem Winkelfaktor von nicht-strukturiertem Glas am nächsten kommt.

Zweckmässigerweise ist die Mikrostruktur herstellbar durch Prägen des aus einer Schmelze gezogenen Glases mit Walzen, welche eine Mikrostruktur aufweisenden und einander gegenüberliegend angeordnet sind, sodass beim Durchgang der noch formbaren Glasscheiben komplementäre Mikrostrukturen in die Glasoberflächen eindrückbar sind. Dies ist ein kostengünstiger Herstellungsprozess. Anspruch 14 bezieht sich auf diesen Herstellungsprozess.

Besonders bevorzugte Mikrostrukturen beschreiben im Schnitt eine Cosinus-, Gauss- oder Kegelfunktion. Diese Strukturen besitzen ein sehr gutes winkelabhängiges Transmissionsverhalten. Weiterer Vorteil ist, dass es praktisch keine Rolle spielt, ob die Strukturen männlich oder weiblich sind. Weitere zweckmässige Mikrostrukturen sind pyramidal mit trigonaler, quadratischer oder hexagonaler Basis, konusförmig, Halbkugeln, oder auf der Glasoberfläche sitzende Kugelabschnitte.

Vorteilhaft beträgt das Verhältnis von Strukturhöhe zur Strukturbreite maximal 50 µm/800 µm, vorzugsweise 30 µm/800 µm und ganz besonders bevorzugt 20 µm/800 µm. Diese Glasscheiben besitzen das höchste Transmissionsvermögen. Von Bedeutung für das Transmissionsvermögen ist ferner, dass das Glas der Glasscheiben einen Eisengehalt von weniger als 0.05 Gewichtsprozenten Eisenoxid, vorzugsweise weniger als 0.03 Gewichtsprozenten Eisenoxid aufweist. Auch ist vorteilhaft, wenn das Glas der Glasscheiben im wesentlichen kein Chromoxid (Cr₂O₃) aufweist.

Die Mikrostrukturen können so ausgebildet sein, dass diese aus dem Glas herausragen, d.h. männlich sind, oder in das Glas eingedrückt, d.h. weiblich sind. Beide Ausführungsformen eignen sich für Glasscheiben für Solaranwendungen.

Gegenstand der vorliegenden Erfindung ist auch eine Glasscheibe mit wenigstens einer Mikrostruktur auf einer Seite der Glasscheibe, wobei die Mikrostruktur aus Erhebungen und dazwischenliegenden Tälern besteht, einen Höhenunterschied zwischen Erhebung und Tal (peak to valley) von maximal 50 µm, vorzugsweise maximal 30 µm und ganz besonder bevorzugt 20 µm aufweist und weiter eine Antireflexschicht auf der Glasscheibe aufgebracht ist. Die Antireflexschicht kann grundsätzlich auf der Mikrostruktur oder auf der abgewandten glatten Glasoberfläche aufgebracht sein. Mittels der Antireflexschicht kann die Transmission bis gegen 100% betragen. Die Antireflexschicht kann hergestellt sein durch bekannte additive oder subtraktive Herstellungsprozesse. Zu den subtraktiven Herstellungsprozessen zählen beispielsweise die Behandlung der Glasoberfläche mit einer Säurelösung (auch gebufferte Säurelösungen) und der Beschuss der Glasoberfläche mit hochenergetischen Partikeln.

Die Antireflexschicht kann ein- oder mehrlagig sein und ist vorzugsweise erhältlich durch ein Sol-Gel-Verfahren, Prägeverfahren, Aufsprühen (spray coating), Aufdampfen oder Aufsputtern. Ein Überblick über die Sol-Gel Technik gibt D.R. Uhlmann, T. Suratwala, K. Davidson, J.M. boulton, G. Teowee in J. Non-Cryst. Solids 218 (1997) 113.

Gemäss einer bevorzugten Ausführungsform ist die Antireflexschicht eine poröse Polymerschicht erhältlich durch Auftragen einer Lösung aus wenigstens zwei unterschiedlichen polymeren Verbindungen mit unterschiedlichen Lösungseigenschaften, Bildung einer Polymerschicht durch Verdunsten des Lösungsmittels und anschliessendem wenigstens teilweisen Entfernen wenigstens einer polymeren Verbindung durch Kontaktieren und Lösen mit einem weiteren Lösungsmittel. Duch dieses Verfahren ist eine poröse Polymerschicht erhältlich mit Poren, deren Dimension kleiner als die Wellenlänge des sichtbaren Lichts ist. Der Brechungsindex von porösen Schichten entspricht dem Mittel des Brechungsindizes des aufgebrachten Materials und der Luft. Durch Variation der Porosität kann der Brechungsindex gezielt eingestellt werden. Dabei können auch sehr kleine Brechungsindizes erreicht werden, die mit herkömmlichen Materialien, z.B. MgF₂, nicht herstellbar waren. Poröse Antireflexschichten sind grundsätzlich auch erhältlich durch ein Sol-Gel-Verfahren oder durch Prägen. Poröse Antireflexschichten sind beispielsweise herstellbar durch Mischungen folgender Kunststoffe: Polymethacrylat. Polymethylmethacrylat, Polystyrol, Polyacrylat, Polyvinylchlorid, Polyvinylpyridin, Polycarbonat, Polycarbamat-Verbindungen und anderen. Von Bedeutung bei der Herstellung der porösen Polymer-Antireflexschichten ist, dass die eingesetzten Polymerverbindungen unterschiedliche Lösungseigenschaften aufweisen, sodass eine Polymerverbindung in einem bestimmten Lösungsmittel bevorzugt gelöst wird. Weiter ist das durchschnittliche Molekulargewicht der eingesetzten Polymerverbindungen so zu wählen, dass die gewünschte Porengrösse und Lösungseigenschaften erreicht wird. Es wird angenommen, dass beim Verdunsten des Lösungsmittels eine teilweise Entmischung der Polymerverbindungen stattfindet, sodass lateral alternierende Bereiche der verschiedenen Polymerverbindungen entstehen. Durch wenigstens teilweises Herauslösen eines der Polymere ergeben sich Poren, die kleiner als die Wellenlänge des sichtbaren Lichtes sein können.

Die Polymer-Verbindungen können grundsätzlich auf die Glasoberfläche aufgebracht werden durch Eintauchen in eine Lösung enthaltend die Polymer-Verbindungen oder durch Aufschleudern (spin-coating). Denkbar ist auch, die porösen Oberflächen durch Prägen herzustellen, indem die poröse Nanostruktur in die Prägewalzen geätzt wird.

Für Anwendungen in der Solartechnik kann die Glasscheibe aussen eine Antireflexschicht aufweisen und auf der abgewandten Glasoberfläche eine Mikrostruktur. Auf diese Weise hat man aussen eine gut zu reinigende Glasoberfläche und weiter durch die Antireflexschicht und die Mikrostruktur eine Glasscheibe mit einem sehr hohen Transmissionsgrad für das sichtbare Licht.

Die Erfindung soll nachfolgend unter Bezugnahme auf die Figuren näher beschrieben werden. Es zeigt:
Figur 1: ein Diagramm, in welchem der Winkelfaktor eines bekannten einseitig strukturierten Glases mit einer Rauhtiefe von 90 µm (peak to valley) als Funktion des Einfallswinkels dargestellt ist;
Figur 2: ein Diagramm, in welchem der Winkelfaktor eines erfindungsgemässen beidseitig strukturierten Glases als Funktion des Einfallswinkels dargestellt ist;
Figur 3: Beispiele verschiedener untersuchter Oberflächenstrukturen;

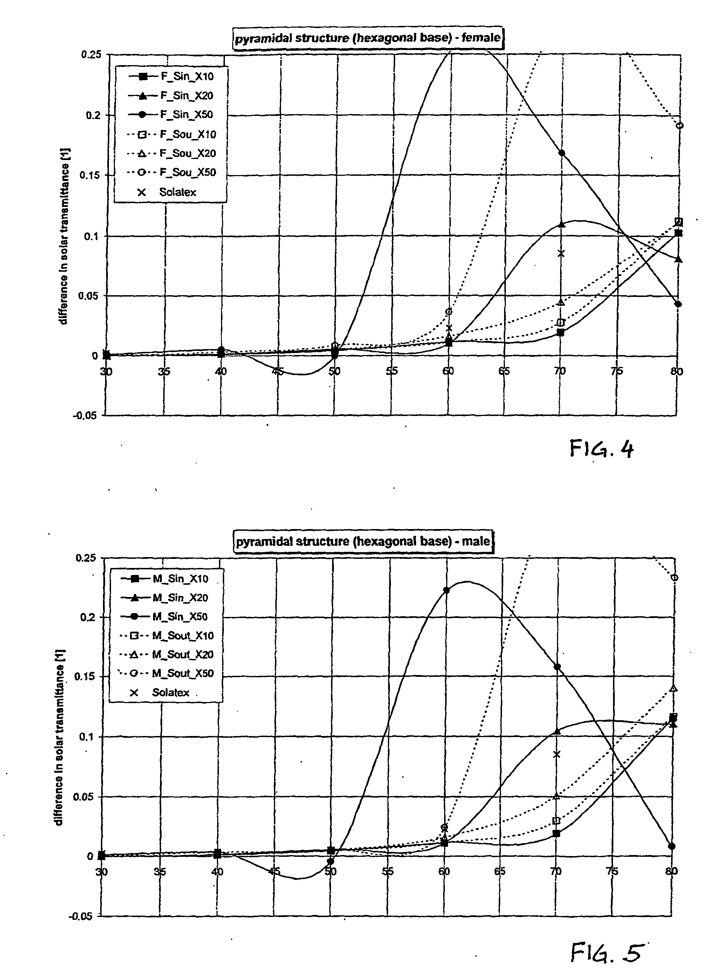

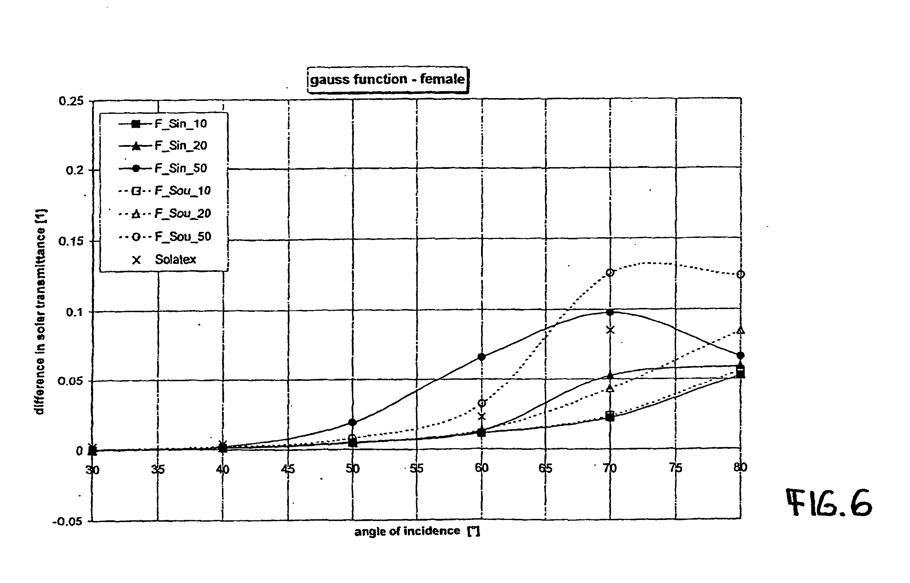

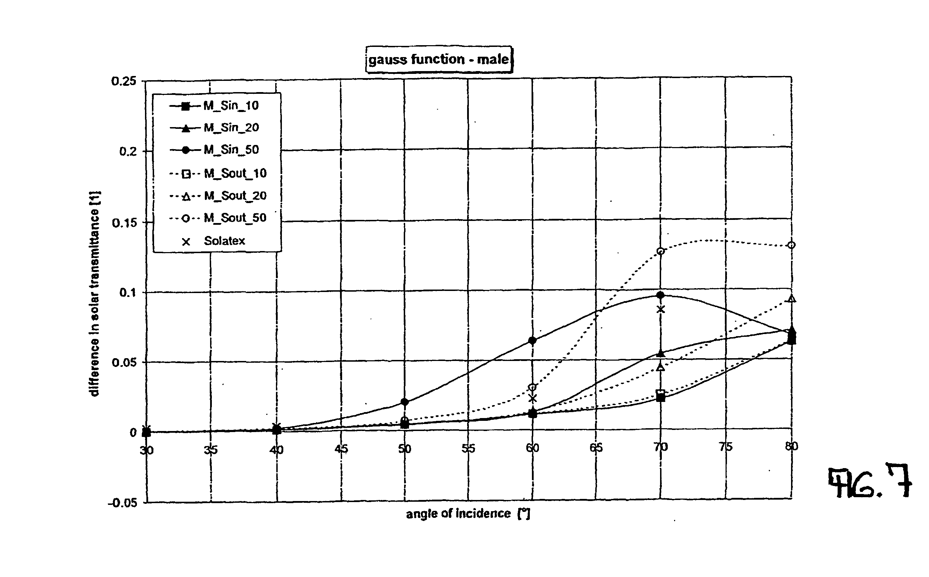

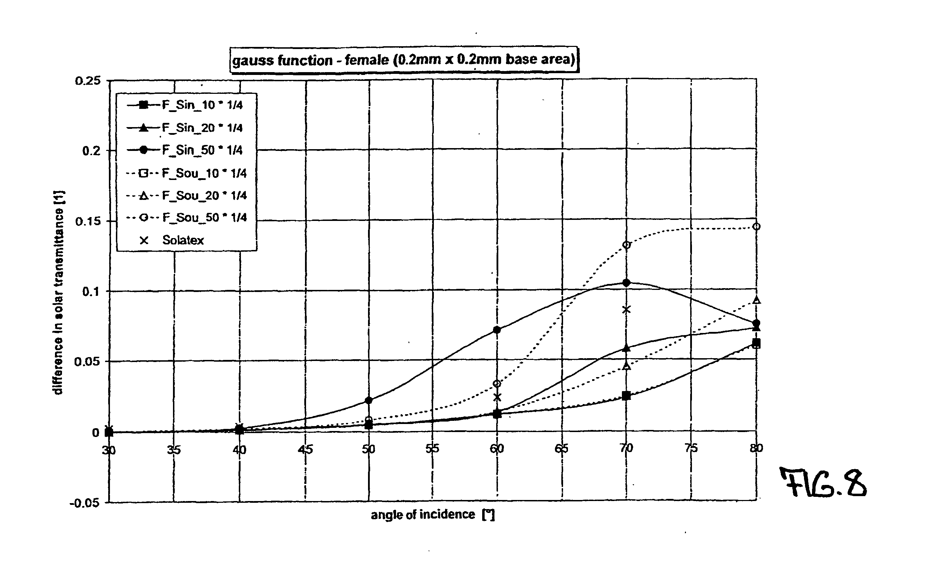

Figur 4: ein Diagramm, in welchem das relative solare Transmissionsvermögen einer im Schnitt kosinusförmigen weiblichen Mikrostruktur zwischen 10 µm und 50 µm Höhe als
Funktion des Einfallswinkels aufgetragen ist;
Figur 5: ein Diagramm, in welchem das relative solare Transmissionsvermögen einer im Schnitt kosinusförmigen männlichen Mikrostruktur zwischen 10 µm und 50 µm Höhe als
Funktion des Einfallswinkels aufgetragen ist;
Figur 6: ein Diagramm, in welchem das relative solare Transmissionsvermögen einer im Schnitt weiblichen gaussförmigen Mikrostruktur zwischen 10 µmund 50 µm Höhe als Funktion des Einfallswinkels aufgetragen ist;
Figur 7: ein Diagramm, in welchem das relative solare Transmissionsvermögen einermännlichen, im Schnitt pyramidalen Mikrostruktur zwischen 10 µm und 50 µm Höhe als Funktion des Einfallswinkels aufgetragen ist;
Figur 8: ein Diagramm, in welchem das relative solare Transmissionsvermögen einerweiblichen, im Schnitt pyramidalen Mikrostruktur zwischen 10 µm und 50 µm Höhe als Funktion des Einfallswinkels aufgetragen ist;
Figur 9: die Transmissionswerte einer im Schnitt gaussförmigen Mikrostruktur, welche der Belichtung zugewandt ist, als Funktion des Einfallswinkels;
Figur 10: die Transmissionswerte einer im Schnitt gaussförmigen Mikrostruktur, welche der Belichtung abgewandt ist, als Funktion des Einfallswinkels.

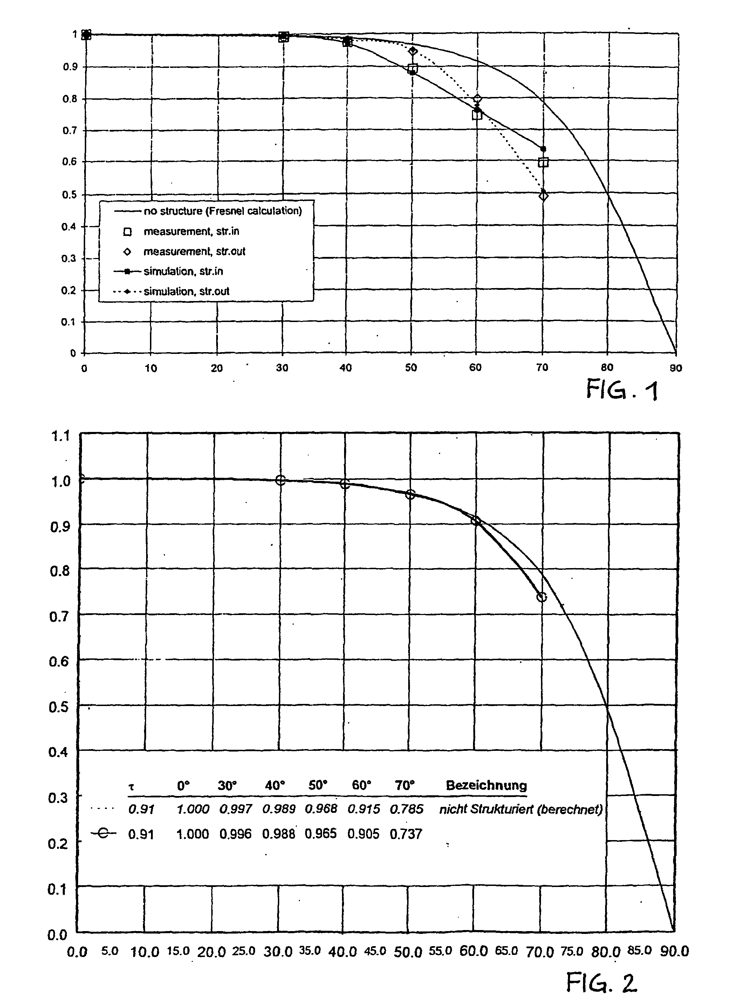

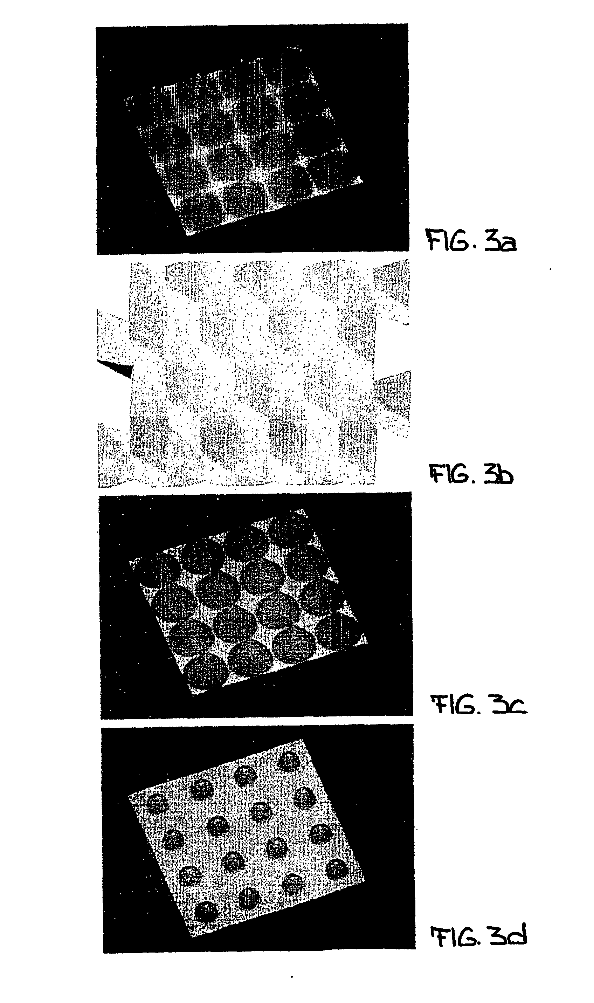

Die Figuren 1 und 2 zeigen Diagramme, in denen der Winkelfaktor eines bekannten, einseitig strukturierten Glases (Figur 1) und eines beidseitig strukturierten Glases (Figur 2) als Funktion des Einfallswinkels dargestellt ist. Unter Winkelfaktor wird definitionsgemäss das Verhältnis des solaren Transmissionsgrades unter variablem Einfallswinkel relativ zu senkrechtem Einfall verstanden. Den höchsten Winkelfaktor besitzen unstrukturierte (glatte) Gläser. Zu Vergleichszwecken sind die Winkelfaktoren eines unstrukturierten Glases jeweils als Referenzkurve in den Figuren mit eingezeichnet. Die gemessenen Gläser wiesen alle eine Dicke von 3.2. respektive 4 mm auf.

Das bekannte Glas mit einer Rauhtiefe von 90 µm wurde gemessen, einmal mit der strukturierten Seite der Lichtquelle abgewandt (also bei einem Kollektor zur Innenseite orientiert ist = "str. in") oder der Lichtquelle zugewandt ist ("str. out"). Es ist ersichtlich, dass die Winkelfaktoren je nach Einfallswinkel bis zu 10% variieren können. Während eine nach aussen orientierte Struktur (Lichtquelle zugewandt) bis zu einem Einfallswinkel von 60 Grad besser ist als die nach innen orientierte Struktur, erweist sich letztere bei einem Einfallswinkel zwischen 60 und 70 Grad als die bessere.

Das erfindungsgemässe Glas mit einer beidseitigen Oberflächenstruktur von 30 µm (peak to valley) erweist sich überraschenderweise als das bessere Glas. Selbst bei einem Einfallswinkel von 70 Grad ist der Winkelfaktor nur unwesentlich schlechter als der Winkelfaktor eines unstrukturierten Glases. Im Vergleich zum bekannten Glas von Figur 1 werden bei allen Einfallswinkeln höhere Transmissionswerte erreicht. Daraus ergibt sich der wesentliche Vorteil, dass im Gegensatz zu einseitig strukturierten Gläsern die Orientierung der strukturierten Oberfläche unbeachtlich ist.

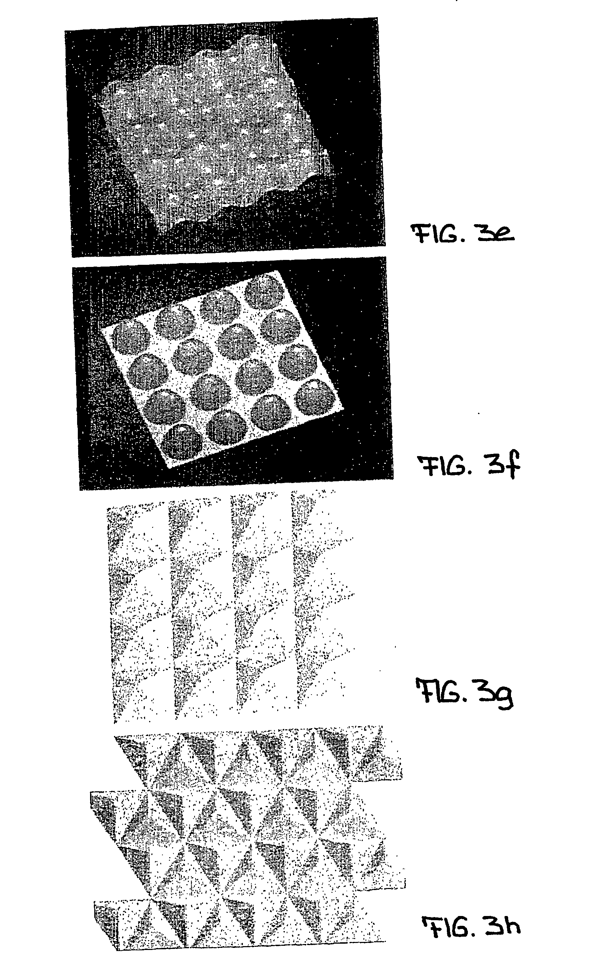

Die Figuren 3a bis 3h zeigen verschiedene mögliche geometrische Oberflächenstrukturen. Diese Strukturen sind Simulationsrechnungen theoretisch zugänglich (z.B. OptiCAD). Dabei kann beispielsweise die Strukturerhebungen (peak to valley) variiert und der Einfluss auf das Transmissionsvermögen festgestellt werden.
Fig. 3a zeigt eine Struktur, welche im Schnitt eine Gauss-Funktion ist. Die Höhe z setzt sich zusammen aus dem Produkt der Gaussfunktionen für den Ort (x,y) in einem Abstand von 800 µm zueinander.
Fig. 3b zeigt eine pyramidale Struktur mit einer hexagonalen Basis. Die Pyramiden ragen aus der Glasoberfläche heraus (männliche Struktur). In x-Richtung (waagrechte Querachse) beträgt der Abstand 693 mm, in y-Richtung 600 µm.
Fig. 3c zeigt eine konusförmige Struktur, welche durch auf dem Glas sitzende Kegel gebildet ist Die Kegelgrundfläche hat einen Durchmesser von 800 µm und einen Abstand von 800 µm zueinander.
Fig. 3d zeigt eine Struktur mit auf dem Glas sitzenden Halbkugeln. Die Halbkugeln haben einen Durchmesser von 200 µm und sind in einem Abstand von 800 µm angeordnet.
Fig. 3e zeigt eine Struktur, welche im Schnitt eine Cosinus-Funktion in Richtung x und y ist. Die Struktur hat eine Periode von 800 µm.
Fig. 3f zeigt eine Struktur mit Kugelabschnitten (männlich), welche in regelmässigen Abständen auf dem Glas angeordnet sind. Der Durchmesser der Kugeln beträgt 800 µm. Die Kugelabschnitte sind 100 µm, 200 µm oder 400 µm (Halbkugel) hoch.
Fig. 3g zeigt eine männliche, pyramidale Struktur. Die Pyramiden sind 4-seitig und besitzen eine quadratische Grundfläche von 800 µm Kantenlänge.
Fig. 3h zeigt ebenfalls eine männliche, pyramidale Struktur, jedoch mit trigonaler Basis. Die Seitenlänge der Grundfläche beträgt 800 µm. Die x-Richtung (Querachse) ist waagrecht.

In den Figuren 6 bis 8 ist die Differenz in der solaren Transmission als Funktion des Einfallswinkels für eine im Schnitt Gauss'sche Mikrostruktur mit einer 800 µm x 800 µm Basisfläche dargestellt Die Differenz der solaren Transmission entspricht der Tansmission der betrachteten Mikrostruktur abzüglich der Transmission eines nichtstrukturierten Glases. Durch diese Darstellungsweise wird eine Spreizung der y-Achse erreicht.

Figur 6 zeigt eine weibliche Mikrostruktur, bei welcher die gaussförmigen Mikrostrukturen in die Glasoberfläche eingedrückt sind. Figur 7 zeigt eine männliche Mikrostruktur, bei welcher die gaussförmigen Mikrostrukturen aus der Glasoberfläche herausragen. Der Vergleich der Kurven zeigt, dass die weiblichen und männlichen Mikrostrukturen bezüglich Transmissionsverhalten praktisch die gleichen Eigenschaften aufweisen. Weiter ist aus den Figuren erkennbar, dass die Mikrostrukturen mit einem peak-to-valley Verhaltnis von 50:1 bei Einfallswinkeln grösser als 40 Grad die schlechteren Transmissionswerte aufweisen. Die Mikrostrukturen sind in der Grösse über einen bestimmten Bereich skalierbar. So sind die Transmissionswerte einer gaussförmigen Mikrostruktur mit einer Basis von lediglich 200 µm x 200 µm (Fig. 8) praktisch gleich wie die Transmissionswerte einer Mikrostruktur mit einer Basis von 800 µm x 800 µm.

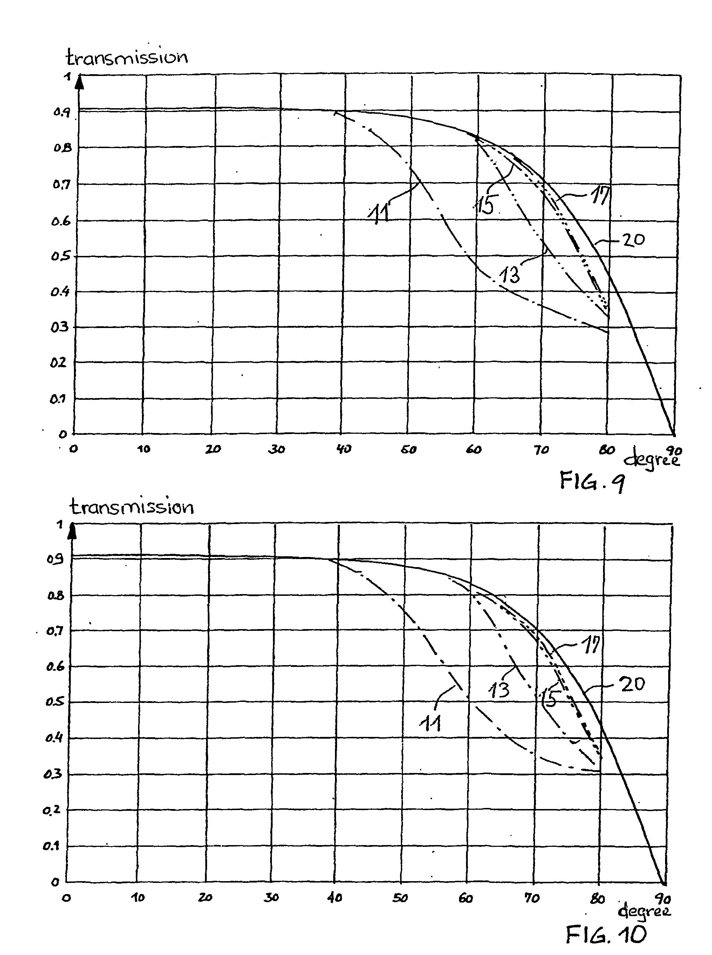

Die Figuren 9 und 10 zeigen den Einfluss der Höhe von konusartigen Erhebungen/Mikrostruktur auf die Transmission (Ordinate) bei unterschiedlichen Einfallswinkeln (Abszisse). In Fig. 9 sind die konusförmigen Mikrostrukturen der Belichtung zugewandt (structure out), in Fig. 10 der Belichtung abgewandt (structure in). Die Kurven 11, 13,15 und 17 entsprechen Mikrostrukturhöhen von 200 µm, 50 µm, 20 µm und 10 µm. Kurve 21 entspricht einem Glas mit nicht-strukturierter (glatter) Glasoberfläche. Aus den Darstellungen geht hervor, dass eine Mikrostruktur von 50 µm Höhe eine wesentlich bessere Transmission bei grossen Einfallswinkeln aufweist als eine Struktur mit 200 µm Höhe. Haben die Mikrostrukturen eine Höhe kleiner als 30 µm, so unterscheiden sich die Transmissionswerte nur noch sehr wenig.

Eine weitere Verbesserung des Transmissionsgrades lässt sich erreichen, wenn - wie oben beschrieben - zusätzlich eine Antireflexschicht auf die Glasscheibe aufgebracht oder in der Glasoberfläche ausgebildet wird.

Die erfindungsgemässe Glasscheibe für Solaranwendungen mit zwei einander gegenüberliegenden, parallelen Oberflächen weist auf beiden Glasoberflächen Mikrostrukturen auf. Die Mikrostrukturen sorgen für eine matte Erscheinung der Glasoberflächen. Die Mikrostrukturen sind regelmässige oder unregelmässig angeordnete Erhebungen und Täler mit einem peak-to-valley Verhältnis von max. 50 µm, vorzugsweise ma. 30 µm und ganz besonders bevorzugt von max. 20 µm. Gemäss einem anderen Aspekt der Erfindung kann die Mikrostruktur überlagert sein mit einer Antireflexschicht. Die Antireflexschicht ist vorzugsweise eine poröse Polymerschicht auf die Glasoberfläche.

## Patentansprüche

1. Glasscheibe mit einer mikrostrukturierten Glasoberfläche, insbesondere für Solaranwendungen, **dadurch gekennzeichnet, dass** wenigstens eine Glasoberfläche eine Mikrostruktur aufweist, welche aus Erhebungen und dazwischenliegenden Tälern besteht und der Höhenunterschied zwischen Erhebung und Tal (peak to valley) maximal 50 µm, vorzugsweise maximal 30 µm und ganz besonders bevorzugt 20 µm beträgt.

2. Glasscheibe nach Anspruch 1, **dadurch gekennzeichnet, dass** beide Glasoberflächen eine Mikrostruktur aufweisen, welche aus Erhebungen und dazwischenliegenden Tälern besteht und der Höhenunterschied zwischen Erhebung und Tal (peak to valley) maximal 50 µm, vorzugsweise maximal 30 µm und ganz besonders bevorzugt 20 µm beträgt.

3. Glasscheibe nach einem der Ansprüche 1 oder 2, **dadurch gekennzeichnet, dass** die Mikrostrukturen im Schnitt eine Cosinus-, Gauss- oder Kegelfunktion beschreiben.

4. Glasscheibe nach einem der Ansprüche 1 bis 3, **dadurch gekennzeichnet, dass** die Mikrostrukturen pyramidal mit trigonaler, quadratischer oder hexagonaler Basis, konusförmig, Halbkugeln, oder auf der Glasoberfläche sitzende Kugelabschnitte sind.

5. Glasscheibe nach einem der Ansprüche 1 bis 4, **dadurch gekennzeichnet, dass** das Verhältnis von Strukturhöhe zur Strukturbreite maximal 50 µm/800 µm, vorzugsweise
30 µm/800 µm und ganz besonders bevorzugt 20 µm/800 µm. beträgt.

6. Glasscheibe nach einem der Ansprüche 1 bis 5, **dadurch gekennzeichnet, dass** das Glas der Glasscheiben einen Eisengehalt von weniger als 0.05 Gewichtsprozenten, vorzugsweise weniger als 0.03 Gewichtsprozenten aufweist.

7. Glasscheibe nach einem der Ansprüche 1 bis 6, **dadurch gekennzeichnet, dass** das Glas der Glasscheiben im wesentlichen kein Chromoxid (Cr₂O₃) aufweist.

8. Glasscheibe nach einem der Ansprüche 1 bis 7, **dadurch gekennzeichnet, dass** die Mikrostrukturen aus dem Glas herausragen, d.h. männlich sind.

9. Glasscheibe nach einem der Ansprüche 1 bis 7, **dadurch gekennzeichnet, dass** die Mikrostrukturen in das Glas eingedrückt, d.h. weiblich sind.

10. Glasscheibe nach einem der Ansprüche 2 bis 9 in Verbindung mit Anspruch 2, **dadurch gekennzeichnet, dass** die Mikrostrukturen in den beiden Glasoberflächen unterschiedlich ausgebildet sind.

11. Glasscheibe nach einem der Ansprüche 1 bis 10, **dadurch gekennzeichnet, dass** eine Antireflexschicht auf die Glasscheibe aufgebracht ist.

12. Glasscheibe nach Anspruch 11, **dadurch gekennzeichnet, dass** die Antireflexschicht auf der Mikrostruktur aufgebracht ist.

13. Glasscheibe nach Anspruch 12, **dadurch gekennzeichnet, dass** die Antireflexschicht eine Polymerschicht ist.

14. Verfahren zur Herstellung einer Glasscheibe gemäss einem der Ansprüche 1 bis 13, **dadurch gekennzeichnet, dass** die Mikrostruktur durch Prägen eines aus der Schmelze gezogenen Glases mittels einander gegenüberliegend angeordneten Walzen hergestellt wird, wobei jedenfalls eine der Walzen eine Oberfläche hat mit einer Mikrostruktur, welche die erwünschte Mikrostruktur in der damit in Kontakt kommenden Oberfläche der Glasscheibe einprägt.

15. Verfahren nach Anspruch 14, **dadurch gekennzeichnet, dass** jedenfalls zwei einander gegenüberliegend angeordneten Walzen Oberflächen haben mit einer Mikrostruktur, welche die erwünschten Mikrostrukturen in den damit in Kontakt kommeden Oberflächen der Glasscheibe einprägen.

16. Verfahren nach Anspruch 14 oder 15, **dadurch gekennzeichnet, dass** eine Polymerschicht durch Auftragen einer Lösung aus wenigstens zwei unterschiedlichen polymeren Verbindungen mit unterschiedlichen Lösungseigenschaften, Bildung einer Polymerschicht durch Verdunsten des Lösungsmittels und anschliessendem wenigstens teilweisen Entfernen einer polymeren Verbindung durch Kontaktieren und Lösen mit einem weiteren Lösungsmittel auf die Glasscheibe aufgebracht wird.

17. Verfahren nach einem der Ansprüche 14 oder 15, **dadurch gekennzeichnet, dass** eine Antireflexschicht durch ein Sol-Gel-Verfahren, Prägeverfahren, Aufdampfen oder Aufsputtern aufgebracht wird.

## Claims

1. A glass disk with a microstructurised glass surface, in particular for solar applications, **characterised in that** at least one of the glass surfaces comprises a microstructure which consists of projections and recesses lying therebetween, and the height difference between projection and recess (peak to valley) is maximal 50 µm, preferably maximal 30 µm and very particularly preferred 20 µm.

2. A glass disk according to claim 1, **characterised in that** both glass surfaces have a microstructure which consists of projections and recesses lying therebetween, and the height difference between projection and recess (peak to valley) is maximal 50 µm, preferably maximal 30 µm and very particularly preferred 20 µm.

3. A glass disk according to open of the claims 1 or 2, **characterised in that** the microstructures in section describe a cosine, Gaussian or conical function.

4. A glass disk according to one of the claims 1 to 3, **characterised in that** the microstructures are pyramidal with a trigonal, square, or hexagonal base, are conical, are hemispheres or are ball sections seated on the glass surface.

5. A glass disk according to one of the claims 1 to 4, **characterised in that** the ratio of structure height to structure width is maximal 50 µm/800 µm, preferably 30 µm/800µm and very particularly preferred 20 µm/800 µm.

6. A glass disk according to one of the claims 1 to 5, **characterised in that** the glass of the glass disks has an iron content of less than 0.05 percent by weight, preferably less than 0.03 percent by weight.

7. A glass disk according to one of the claims 1 to 6, **characterised in that** the glass of the glass disks essentially comprises no chromium oxide (Cr₂O₃).

8. A glass disk according to one of the claims 1 to 7, **characterised in that** the microstructures project out of the glass, i.e. are male.

9. A glass disk according to one of the claims 1 to 7, **characterised in that** the microstructures are pressed into the glass, i.e. are female.

10. A glass disk according to one of the claims 2 to 9 in combination with claim 2, **characterised in that** the microstructures in the two glass surfaces are formed differently.

11. A glass disk according to one of the claims 1 to 10, **characterised in that** an antireflex layer is deposited onto the glass disk.

12. A glass disk according to claim 11, **characterised in that** the antireflex layer is deposited on the microstructure.

13. A glass disk according to claim 12, **characterised in that** the anitireflex layer is a polymer layer.

14. A method for manufacturing a glass disk according to one of the claims 1 to 13, **characterised in that** the microstructure is manufactured by embossing a glass which is drawn from the molten mass by way of rollers arranged lying opposite one another, wherein at least one of the rollers has a surface with a microstructure which embosses the desired microstructure in the surface of the glass disk which comes into contact with this.

15. A method according to claim 14, **characterised in that** at least two rollers arranged opposite one another have surfaces with a microstructure which emboss the desired microstructures into the surface of the glass disk which comes into contact with this.

16. A method according to claim 14 or 15, **characterised in that** a polymer layer is brought onto the glass disk by way of depositing a solution of at least two different polymeric compounds with different dissolution properties, forming a polymer layer by evaporating the solvent and subsequently at least partly removing a polymeric compound by contacting and dissolving with a further solvent.

17. A method according to one o the claims 14 or 15, **characterised in that** the antireflex layer is deposited by a sol-gel method, embossing method, vaporisation or sputtering.

## Revendications

1. Carreau en verre avec une surface en verre microstructuré, en particulier pour applications solaires, **caractérisé en ce qu'**au moins l'une des surfaces en verre présente une microstructure qui est constituée par des bosses et des creux situés entre celles-ci et la différence de hauteur entre bosse et creux (peak to valley) est de 50 µm au maximum, de préférence de 30 µm au maximum et de manière tout particulièrement préférée de 20 µm.

2. Carreau en verre selon la revendication 1, **caractérisé en ce que** les deux surfaces de verre présentent une microstructure qui est constituée par des bosses et des creux situés entre celles-ci et la différence de hauteur entre bosse et creux (peak to valley) est de 50 µm au maximum, de préférence de 30 µm au maximum et de manière tout particulièrement préférée de 20 µm.

3. Carreau en verre selon l'une des revendications 1 ou 2, **caractérisé en ce que** les microstructures décrivent en coupe une fonction cosinus, de Gauss ou conique.

4. Carreau en verre selon l'une des revendications 1 à 3, **caractérisé en ce que** les microstructures sont pyramidales avec une base trigonale, carrée ou hexagonale, de forme conique, des hémisphères ou des segments sphériques situés sur la surface de verre.

5. Carreau en verre selon l'une des revendications 1 à 4, **caractérisé en ce que** le rapport de la hauteur de la structure et de la largeur de la structure est au maximum de 50 µm/800 µm, de préférence de 30 µm/800 µm et de manière tout particulièrement préférée de 20 µm/800 µm.

6. Carreau en verre selon l'une des revendications 1 à 5, **caractérisé en ce que** le verre des carreaux en verre présente une teneur en fer inférieure à 0,05 % en poids, et de préférence inférieure à 0,03 % en poids.

7. Carreau en verre selon l'une des revendications 1 à 6, **caractérisé en ce que** le verre des carreaux en verre substantiellement ne présente pas d'oxyde de chrome (Cr₂O₃).

8. Carreau en verre selon l'une des revendications 1 à 7, **caractérisé en ce que** les microstructures font saillie du verre, c'est-à-dire qu'elles sont mâles.

9. Carreau en verre selon l'une des revendications 1 à 7, **caractérisé en ce que** les microstructures sont enfoncées dans le verre, c'est-à-dire qu'elles sont femelles.

10. Carreau en verre selon l'une des revendications 2 à 9 en relation avec la revendication 2, **caractérisé en ce que** les microstructures sont configurées différentes dans les deux surfaces de verre.

11. Carreau en verre selon l'une des revendications 1 à 10, **caractérisé en ce qu'**une couche antiréflex est appliquée sur le carreau en verre.

12. Carreau en verre selon la revendication 11, **caractérisé en ce que** la couche antiréflex est appliquée sur la microstructure.

13. Carreau en verre selon la revendication 12, **caractérisé en ce que** la couche antiréflex est une couche au polymère.

14. Procédé pour la fabrication d'un carreau en verre selon l'une des revendications 1 à 13, **caractérisé en ce que** la microstructure est fabriquée en estampant un verre tiré de la fonte au moyen de rouleaux placés en face l'un de l'autre, de toute façon l'un des rouleaux ayant respectivement une surface avec une microstructure qui estampe la microstructure souhaitée dans la surface du carreau qui vient en contact.

15. Procédé selon la revendication 14, **caractérisé en ce que** de toute façon deux rouleaux placés l'un en face de l'autre ont des surfaces avec une microstructure qui estampent les microstructures souhaitées dans les surfaces du carreau qui viennent en contact.

16. Procédé selon la revendication 14 ou 15, **caractérisé en ce qu'**une couche à polymère est appliquée sur le carreau en verre par application d'une solution d'au moins deux combinaisons polymères différentes avec différentes propriétés de solution, formation d'une couche polymère par évaporation du solvant et ensuite enlèvement au moins partiel d'une combinaison polymère par contact et dissolution avec un autre solvant.

17. Procédé selon l'une des revendications 14 ou 15, **caractérisé en ce qu'**une couche antiréflex est appliquée par un procédé sol-gel, par estampage, métallisation sous vide ou pulvérisation cathodique.
